# EUROPÄISCHE PATENTSCHRIFT

(11) **EP 1 235 284 B1**
(45) Veröffentlichungstag und Bekanntmachung des Hinweises auf die Patenterteilung: **01.10.2008**
(21) Anmeldenummer: 02002920.3
(22) Anmeldetag: 09.02.2002
(51) Int. Cl.: H01L 41/08, H01L 41/22, B64C 27/615

(54) **Piezokeramische Platte und Verfahren zum Herstellen derselben**
Piezoceramic plate and method of manufacturing the same
Plaque piézocéramique et sa méthode de fabrication

(30) Priorität: 09.02.2001 DE 10106057
(43) Veröffentlichungstag der Anmeldung: 28.08.2002
(73) Patentinhaber: EADS Deutschland GmbH, 81663 München (DE)
(72) Erfinder: Jänker, Peter, Dr., 85748 Garching (DE); Hermle, Frank, 81673 München (DE)

(56) Entgegenhaltungen:
- EP-A- 0 517 039
- US-A- 4 683 396
- US-A- 4 876 776
- US-A- 5 440 193
- PATENT ABSTRACTS OF JAPAN Bd. 007, Nr. 062 (E-164), 15. März 1983 (1983-03-15) -& JP 57 207385 A (MATSUSHITA DENKI SANGYO KK), 20. Dezember 1982 (1982-12-20)
- PATENT ABSTRACTS OF JAPAN Bd. 010, Nr. 213 (E-422), 25. Juli 1986 (1986-07-25) -& JP 61 051884 A (HITACHI LTD), 14. März 1986 (1986-03-14)

## Beschreibung

Die vorliegende Erfindung betrifft eine piezokeramische Platte sowie ein Verfahren zum Herstellen derselben.

Piezoelektrische Elemente finden in vielen Gebieten der Technik Anwendung, wie beispielsweise in elektronischen Bauelementen für die Kfz-, Flugzeug- oder Medizintechnik, um nur einige Bereiche zu nennen. Es ist bekannt, dass piezoelektrische Materialien ihre Form beim Anlegen eines elektrischen Feldes variieren bzw. ein elektrisches Signal erzeugen, wenn eine mechanische Kraft auf das piezoelektrische Material einwirkt. Mit anderen Worten, diese Werkstoffe zeigen unter Einwirkung von mechanischem Druck den Effekt auf, das Ladungen an ihrer Oberfläche induziert werden, sowie den inversen Effekt, der Längen- bzw. Dickenänderung des Werkstoffes beim Anlegen einer äußeren Spannung.

In jüngster Zeit sind piezoelektrische Materialien in Aktuatorsystemen verwendet worden. Derartige Aktuatorsysteme werden beispielsweise in der Luftfahrt zur Steuerung von Rotorklappen und dergleichen eingesetzt. Hierbei können sogenannte Piezostacks (z.B. DE 196 48 545, DE 196 46 676) verwendet werden, um deren Längenausdehnung aufgrund eines elektrischen Feldes über Hebelanordnungen auf die an einem Rotorblatt angeordneten Klappen zu übertragen.

Zudem ist es im Rahmen neuer Entwicklungen erstrebenswert, eine Verwindung von arodynamischen Strukturen auf geeignete Weise steuern zu können. Zu diesem Zweck werden beispielsweise piezoelektrische Schichten bzw. Fasern auf Flügeltragflächen oder Rotorblätter aufgetragen oder in Faserverbundstrukturen integriert, wie z.B. von Hagood et. al. in US 6,048,622 und US 5,869,189 beschrieben. Darin sind Verbundstrukturen zum Erfassen und/oder Bewirken struktureller Verformungen offenbart, die unter anderem eine Verbundschicht mit parallel ausgerichteten piezoelektrischen Fasern und interdigital ausgebildeten Elektrodenschichten zum Anlegen und/oder Erfassen einer elektrischen Spannung in Faserachsrichtung aufweisen. Ferner können auf diese Weise mehrschichtige Verbundstrukturen mit gewünschter Aniosotropie aufgebaut werden. Die piezoelektrischen Fasern weisen typischerweise einen Durchmesser zwischen 5 und 200 µm auf und sind in eine weiche, verformbare Polymermatrix eingebettet, so dass eine folienartige Piezofaserschicht entsteht.

Derartige folienartige Piezoschichten haben jedoch den Nachteil hoher Herstellungskosten, die eine kommerzielle Serienanwendung nur begrenzt möglich machen. Ferner weisen derartige Piezofolie eine sehr hohe Flexibilität und damit eine nur geringe Steifigkeit auf. Dies kann für bestimmte Anwendungen von Nachteil sein. FürAnwendungen im Rotorblattbereich ist eine ausreichende Steifigkeit bei gleichzeitiger Verformbarkeit erforderlich. D.h., die verwendeten Piezostrukturen benötigen eine gewisse Festigkeit und Steifigkeit, sowie die Fähigkeit sich in gewissem Maße an gekrümmte Strukturen anzupassen, ohne dass Risse in der Struktur entstehen. Folglich ist ein Kompromiß aus Festigkeit und Flexibilität erforderlich, der mit den bekannten Piezofolien nicht oder nur bedingt erreicht wird.

Gleichzeitig schließt sich die Verwendung von gesinterten keramischen Platten aus piezoelektrischem Material aus, da sich diese nicht an gekrümmte Formen anpassen, sondern aufgrund ihrer hohen Brüchigkeit beim Verbiegen reißen oder zerbrechen,

Druckschrift US 4,683,396 A offenbart einen Verbund-Ultraschall-Transducer sowie ein Verfahren zum Herstellen desselben. Dabei werden in eine piezoelektrische Keramik Aussparungen eingebracht, die z, B, mit einem Polymer oder einem Epoxyharz gefüllt werden.

Auch bei dem in JP 57207385 A beschriebenen Herstellungsverfahren für ein piezoelektrisches Verbundelement werden in einer piezoelektrischen Keramik eingebrachte Aussparungen aufgefüllt, beispielsweise mit einem Epoxyharz.

In Druckschrift US 5,440,193 ist die Verwendung einer piezokeramischen Platte zum Erfassen oder zur Bewirkung einer Verformung eines Rotorblattes oder einer Tragfläche offenbart, wobei die piezokeramische Platte auf der Außenhaut der Fläche eine Verbundstruktur mit dieser bildet.

Es ist somit die Aufgabe der vorliegenden Erfindung, eine piezoelektrische Struktur zu schaffen, die einerseits eine ausreichende Festigkeit bzw. Steifigkeit aufweist und andererseits flexibel und verbiegbar ist, so dass sie für das Aufbringen auf gewölbte Flächen sowie die Integration in Verbundstrukturen geeignet ist.

Diese Aufgabe wird durch das Verfahren zur Herstellung einer piezokeramischen Platte gemäß Patentanspruch 1 gelöst. Weitere vorteilhafte Merkmale, Aspekte und Details der Erfindung ergeben sich aus den Unteransprüchen, der Beschreibung und den Zeichnungen.

Nachfolgend wird die Erfindung anhand der beigefügten Abbildungen in näheren Einzelheiten erläutert, in denen zeigt:
- Fig. 1: eine schematische dreidimensionale Darstellung einer piezokeramischen Platte gemäß eines Beispiels zur Verauschaulichung der Erfindung;
- Fig. 2: eine vergrößerte Darstellung eines Ausschnitts der in Fig. 1 gezeigten Struktur;
- Fig. 3: eine schematische zweidimensionale Darstellung der in Fig. 1 gezeigten Struktur;
- Fig. 4: eine schematische zweidimensionale Darstellung einer piezokeramischen Platte mit versetzten Ausbrüchen;
- Fig. 5: eine schematische zweidimensionale Darstellung einer piezokeramischen Platte mit geschwungenen Ausbrüchen; und
- Fig. 6: eine schematische dreidimensionale Darstellung einer piezokeramische Platte gemäß der Ausführungsform der Erfindung.

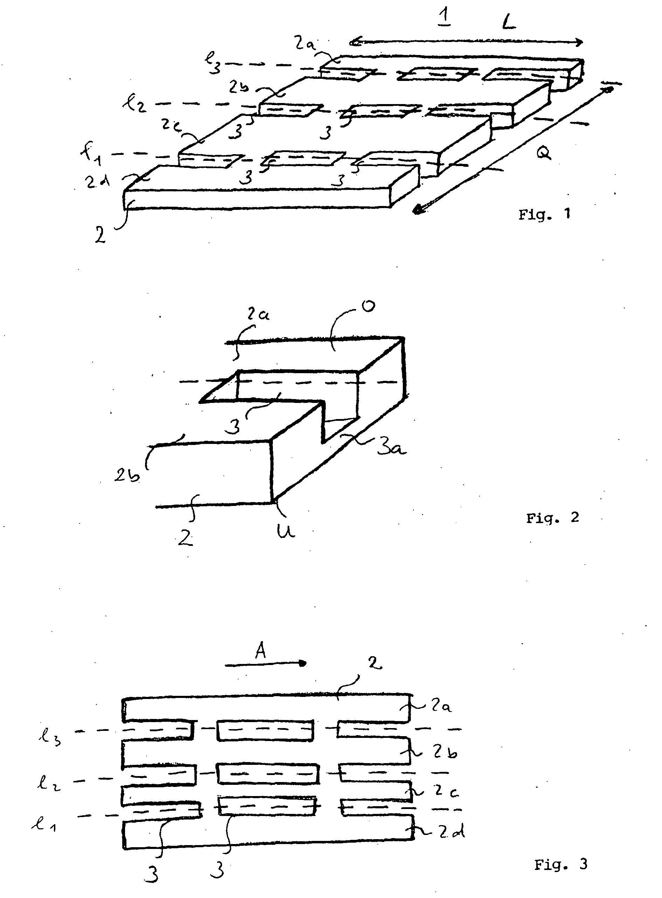

Fig. 1 zeigt schematisch in dreidimensionaler Darstellung eine piezokeramische Platte gemäß eines Beispiels zur Veranschaulichung der Erfindung. Die Platte 1 besteht im wesentlichem aus einem Basismaterial 2, das eine piezoelektrische Keramik ist. Die piezoelektrische Keramik 2 wird beispielsweise durch ein bekanntes Sinterverfahren hergestellt. Derartige gesinterte Piezoplatten lassen sich auf einfache Weise, kostengünstig und in beliebigen Abmessungen herstellen. Da eine derartige gesinterte piezoelektrische Platte mit einer typischen Dick von 20 µm bis 500 µm eine hohe Steifigkeit aufweist und brüchig ist, so dass beim Verbiegen Risse in der Platte entstehen oder diese sogar bricht, sind besondere Maßnahmen erforderlich, um derartige piezoelektrische Keramiken an gewölbte bzw. gekrümmte Strukturen anpassen zu können. Erfindungsgemäß wird auf geeignete Weise die piezoelektrische Keramik 2 in eine Vielzahl von Teilbereiche unterteilt, wobei die einzelnen Teilbereiche durch elastische Bereiche derart miteinander verbunden sind, dass eine felxible Struktur entsteht, die sich leicht an gewölbte Strukturen anpassen läßt.

Diese Teilbereiche sind in Fig. 1 mit Bezugszeichen 2a, 2b ... bezeichnet und ergeben sich beispielsweise durch eine gedachte Linie I₁, I₂, I₃ entlang der Bereiche 3. Es ist anzumerken, dass die gedachten Linien I₁, I₂, I₃ für die Funktionsweise der erfindungsgemäßen Platte irrelevant sind. Sie dienen lediglich zur Beschreibung und somit zum einfacheren Verständnis der Anordnung. Selbstverständlich kann das Basismaterial 2 gedanklich auch in andere Teilbereiche unterteilt werden.

Die in Fig. 1 mit Bezugsziffer 3 bezeichneten Bereiche sind Ausbrüche bzw. Durchbrüche, die mit Hilfe eines nicht dargestellten Schneidwerkzeugs in das Basismaterial 2 eingebracht werden. Das Schneidwerkzeug kann hierbei eine geeignete messerartige Struktur oder eine stempelartige, mit Schneiden versehene Struktur oder Ähnliches sein. Das Schneidwerkzeug wird hierzu an eine Oberfläche der keramischen Platte angelegt, und anschließend wird das Piezomaterial in den Bereichen 3 entweder ganz oder teilweise entfernt. Bei gesamter Entfernung des Materials in den Bereichen 3 handelt es sich um sogenannte Durchbrüche, wie in Fig. 1 dargestellt ist. Wird jedoch lediglich ein Teil des Materials in den Bereichen 3 entfernt, so dass ein unterer Stegbereich 3a übrig bleibt, wie das in Fig. 2 dargestellt ist, handelt es sich um sogenannte Ausbrüche. Es sei angemerkt, dass im Folgenden lediglich der Begriff "Ausbruch" verwendet wird. Die Verwendung dieses Begriffs bedeutet jedoch nicht, dass die vorliegende Erfindung auf die Ausgestaltung gemäß Fig. 2 begrenzt ist, sondern soll auch die Ausgestaltung gemäß Fig. 1 sowie die der nachfolgenden Strukturen beinhalten.

Die Ausbrüche 3 können hierbei in der piezoelektrischen Keramik 2 entlang einer Vorzugsrichtung, die in Fig. 3 mit Pfeil A bezeichnet ist, angeordnet sein. Fig. 3 zeigt in zweidimensionaler Darstellung eine Draufsicht auf die in Fig. 1 dargestellte piezokeramische Platte 1. Wie aus Fig. 3 zu sehen ist, sind die Durchbrüche gleichmäßig und parallel zueinander mit Längsrichtung in Pfeilrichtung A weisend ausgerichtet. Die Durchbrüche weisen hierbei typischerweise eine Breite von 20 µm auf. Durch Variation der Breite kann das Maß an Flexibilität bzw. Steifigkeit verändert werden. Je nach gewünschter Flexibilität können die Durchbrüche ebenso voneinander unterschiedlich beabstandet sein. Dabei wird eine größere Flexibilität der fertigen Struktur erzielt, desto dichter die einzelnen Durchbrüche zueinander angeordnet sind.

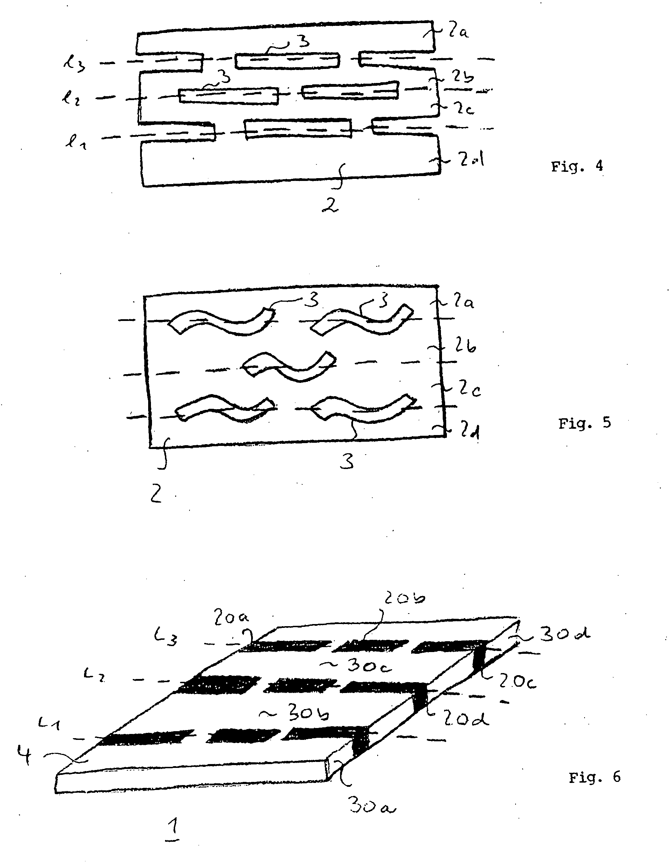

Daneben können die Ausbrüche 3 auch zueinander versetzt, mit Ausrichtung in Vorzugsrichtung A angeordnet sein, wie das in Fig. 4 schematisch dargestellt ist. Die Form der Ausbrüche 3 ist nicht auf eine lineare Form bzw. eine bestimmte Ausrichtung begrenzt. Die Ausbrüche können auch eine wellenförmige Gestalt (vgl. Fig. 5) oder eine andersartig beliebig geschwungene Form aufweisen. Die Wahl der Ausbruchsform hängt jeweils vom gewünschten Anwendungszweck bzw. von der Form des verwendeten Schneidwerkzeugs ab.

Nachdem das Basismaterial 2 in den Bereichen 3 entfernt ist, werden die Ausbrüche 3 mit einem flexiblen Material 4 gefüllt. Das flexible Material 4 ist hierbei beispielsweise ein Polymer, ein Epoxyharz, ein Imprägnierharz oder ein sonstiger Isolierstoff. Nach dem Füllen der Bereiche 3 mit dem flexiblen Material 4 ist in der Regel ein Aushärten oder Trocknen, je nach verwendetem Material, erforderlich. Für den Fall, dass das flexible Material 4 nach diesem Arbeitsschritt über die Konturkanten übersteht, d.h. auf den Oberflächen O bzw. U hervorsteht, ist ein anschließendes Abschleifen möglich, so dass man eine glatte Oberfläche erhält.

Die so erhaltene piezokeramische Platte 1 zeichnet sich insbesondere durch eine ausreichende Festigkeit bzw. Steifigkeit aus und kann sowohl in Längsrichtung L als auch in Querrichtung Q (vgl. Fig. 1) elastisch verbogen werden. Dies ermöglicht ein Anpassen der piezokeramischen Platte an gekrümmte Oberflächen, wie das beispielsweise bei der Verwendung in Rotorblättern oder Tragflächen erforderlich ist. Hierbei ist zudem von Vorteil, das die Platte auch mehrmals nacheinander an Formen mit unterschiedlichen Krümmumgsradien angepaßt werden kann, so dass eine reversible Verformung möglich ist. Ferner hat die erfindungsgemäße Struktur im Vergleich zu den bekannten piezoelektrischen Schichten bzw. Folien den Vorteil, dass ein sehr hoher Füllgrad erreicht wird und dass die Herstellungskosten im Vergleich zu Piezofaserschichten erheblich reduziert sind.

Zur Kontaktierung der piezoelektrischen Elemente sind Elektodenstrukturen erforderlich, die jedoch aus Gründen der besseren Übersicht in den Fig. 1 - 6 nicht dargestellt sind. Die Elektrodenstrukturen können auf einer oder beiden Oberflächen der piezokeramischen Platte angeordnet sein. Hierbei können bekannte interdigitale Strukturen oder andere geeignete Anordnungen verwendet werden.

Ferner ist anzumerken, dass nach dem Auffüllen der Ausbrüche 3 mit flexiblen Material 4 an die piezokeramische Platte eine elektrische Spannung zum Polarisieren der Piezokeramik angelegt werden kann. Auf diese Wiese kann die Polarisierung der piezoelektrischen Bereiche separat von der Herstellung der eigentlichen piezoelektrischen Platte durchgeführt werden, was wiederum aus Praktikabilitäts- und Handhabbarkeitsaspekten vorteilhaft ist.

Die erfindungsgemäße piezokeramische Platte wird derart hergestellt, dass zunächst das plattenförmige Basismaterial aus piezoelektrischer Keramik 2 zerkleinert wird. Diese Zerkleinerung kann entweder mit Hilfe eines Mörsers, eines geeigneten Presswerkzeuges oder wiederum mit einem messerförmigen Schneidwerkzeug erfolgen. Dieses zerkleinerte Basismaterial stellt die oben genannten Teilbereiche aus piezoelektrischer Keramik dar, die in Fig. 6 mit Bezugszeichen 20a, 20b ... bezeichnet sind. Diese Teilbereiche aus zerkleinertem Basismaterial werden anschließend in ein flexibles Material 4, das wiederum ein Polymer, ein Epoxyharz oder dergleichen ist, eingebettet. Hierbei können die Teilbereiche aus piezoelektrischer Keramik 20a, 20b ... entweder statistisch verteilt oder gleichmäßig in eine bestimmte Vorzugsrichtung ausgerichtet sein. Letzteres ist in Fig. 6 dargestellt. Die eingangs erwähnten elastischen Bereiche, die die Vielzahl der Teilbereiche 20a, 20b ... miteinander verbinden, ist in der Ausführungsform gemäß Fig. 6 das die Teilbereiche 20a, 20b ... umgebende flexible Material 4. Ebenso kann das flexible Material 4 gedanklich in verschiedene Bereiche unterteilt werden, was in Fig. 6 durch die gestrichelt dargestellten Linien L₁, L₂ und L₃ dargestellt ist. Dadurch ergeben sich die verschiedenen elastischen Bereiche, die mit Bezugsziffern 30a, 30b ... bezeichnet sind.

Die vorliegende Erfindung, die kostengünstig hergestellt werden kann, zeichnet sich durch eine hohe Flexibilität bei gleichzeitig ausreichender Steifigkeit aus. Die erfindungsgemäße piezokeramische Platte kann leicht an gekrümmte Oberflächen angepasst werden, ohne dass Risse oder Brüche in der Plate entstehen. Diese elastische Verbiegbarkeit ermöglicht auch ein wiederholtes Verformen bzw. Krümmen. Daneben kann eine derartige flexible piezokeramische Platte auch auf einfache Weise in Verbundstrukturen integriert werden. Ferner ist eine Anwendung zum Erfassen und/oder Bewirken einer Verformung bzw. Verwindung von gewölbten Strukturen, wie zum Beispiel aerodynamische Strukturen, möglich. Die erfindungsgemäße Platte kann z.B. auf Flugzeugtragflächen, Rotorblättern etc. aufgebracht oder in derartige Tragflächenstrukturen integriert werden.

## Patentansprüche

1. Verfahren zum Herstellen einer elastisch verbiegbaren piezokeramischen Platte (1), **umfassend die Schritte**
Zerkleinern eines gesinterten piezokeramischen Materials in eine Vielzahl von piezokeramischen Teilbereichen (20a, 20b ...) (2);
Einbetten der Vielzahl von Teilbereichen (20a, 20b ...) in ein flexibles Material (4), so dass die Vielzahl von Teilbereichen (20a, 20b ...) über durch das flexible Material (4) gebildete elastische Bereiche (30a, 30b ...) miteinander verbunden sind; und
Trocknen oder Aushärten des flexiblen Materials (4).

2. Verfahren nach Anspruch 1, wobei als flexibles Material (4) ein Polymer, ein Epoxyharz, ein Imprägnierharz oder ein sonstiger Isolierstoff verwendet wird

3. Verfahren nach Anspruch 1 oder 2, wobei auf der Platte (1) ein- oder beidseitig Elektroden zur Stromversorgung der piezokeramischen Teilbereiche (20a, 20b ...) angeordnet werden.

4. Verfahren nach einem der vorangegangenen Ansprüche, wobei die Vielzahl von Teilbereichen (20a, 20b ...) statistisch verteilt oder in einer Vorzugsrichtung in dem flexiblen Material (4) angeordnet werden.

## Claims

1. Method of manufacturing an elastically bendable piezoceramic plate (1), comprising the steps of
breaking up a sintered piezoceramic material into a multiplicity of piezoceramic partial regions (20a, 20b ...) (2);
embedding the multiplicity of partial regions (20a, 20b ...) in a flexible material (4), so that the multiplicity of partial regions (20a, 20b ...) are connected to one another by means of elastic regions (30a, 30b ...) formed by the flexible material (4); and
drying or hardening the flexible material (4).

2. Method according to Claim 1, a polymer, an epoxy resin, an impregnating resin or some other insulating material being used as the flexible material (4).

3. Method according to Claim 1 or 2, electrodes being arranged on one or both sides of the plate (1) to supply power to the piezoceramic partial regions (20a, 20b ...).

4. Method according to one of the preceding claims, the multiplicity of partial regions (20a, 20b ...) being randomly distributed or arranged in a preferential direction in the flexible material (4).

## Revendications

1. Procédé pour fabriquer une plaque piézocéramique (1) pouvant être cintrée élastiquement, comprenant les étapes suivantes:
broyage d'un matériau piézocéramique fritté en une multitude de zones piézocéramiques partielles (20a, 20b, ...) (2);
enrobage de la multitude de zones piézocéramiques partielles (20a, 20b, ...) dans un matériau flexible (4), de telle manière que la multitude de zones partielles (20a, 20b, ...) soient assemblées les unes aux autres au moyen de zones élastiques (30a, 30b, ...) formées par le matériau flexible (4); et
séchage ou durcissement du matériau flexible (4).

2. Procédé selon la revendication 1, dans lequel on utilise comme matériau flexible (4) un polymère, une résine époxy, une résine d'imprégnation ou une autre matière isolante.

3. Procédé selon la revendication 1 ou 2, dans lequel on dispose sur la plaque (1), sur une ou sur les deux faces, des électrodes pour l'alimentation électrique des zones partielles piézoélectriques (20a, 20b, ...).

4. Procédé selon l'une quelconque des revendications précédentes, dans lequel on répartit la multitude de zones partielles (20a, 20b, ...) de manière statistique ou on les dispose dans une direction préférée dans le matériau flexible (4).
